# EUROPEAN PATENT SPECIFICATION

(11) **EP 2 096 683 B1**
(45) Date of publication and mention of the grant of the patent: **11.05.2011**
(21) Application number: 08290176.0
(22) Date of filing: 26.02.2008
(51) Int. Cl.: H01L 31/18, H01L 27/146

(54) **Method for fabricating a semiconductor substrate**
Verfahren zur Herstellung eines Halbleitersubstrats
Procédé pour la fabrication d'un substrat semi-conducteur

(43) Date of publication of application: 02.09.2009
(73) Proprietor: S.O.I. TEC Silicon, 38190 Bernin (FR)
(72) Inventor: Drouin, Alexis, 38700 La Tronche (FR); Aspar, Berhard, 38330 Saint Ismier (FR); Desrumeaux, Christophe, 38530 La Buissiere (FR); Ledoux, Olivier, 38000 Grenoble (FR)
(74) Representative: Grünecker, Kinkeldey, Stockmair & Schwanhäusser Anwaltssozietät

(56) References cited:
- US-A- 5 137 837
- US-A1- 2005 233 493
- US-B1- 6 326 280

## Description

The invention relates to a method for fabricating a semiconductor substrate starting from a silicon on insulator (SOI) type substrate.

In the optoelectronics, special substrates are needed which are for example used for image sensors, which find their application in video or photographic cameras. In these substrates, which are based on SOI type substrates, a buried oxide (BOX) is provided on a base through which photons can be collected from the backside of the wafer. Alternatively, the image sensors formed in the device layer of the SOI substrate could be transferred to a final substrate to expose the backside of the sensors. A thin highly doped p++(or n++) first semiconductor layer is directly provided on the buried oxide and a second semiconductor layer with a lower dopant concentration (p-/n- layer) is provided on the first semiconductor layer.

In the prior art, this kind of special substrate was prepared using a highly doped substrate as the donor wafer in the conventional Smartcut^{™} technology. This method typically comprises the steps of providing a donor substrate, e.g. a silicon wafer, providing an insulating layer on the donor substrate and creating a predetermined splitting area inside the donor substrate, which is achieved by implanting atomic species or ions, like helium or hydrogen ions, into the donor substrate. In the next step the donor substrate is bonded to a base substrate, e.g. a further silicon wafer, such the insulating layer is sandwiched between handle and donor substrate. Subsequently, the remainder of the donor substrate is detached from the bonded donor-base substrate at the predetermined splitting area following a thermal and/or mechanical treatment upon the predetermined splitting area. As a result a semiconductor on insulator (SOI) substrate is obtained. Document US-A-5137 837 describes a SOI-based semiconductor substrate.

However, the use of a highly doped substrate can lead to the following problem: It can be observed that cross-contamination from one donor wafer, e.g. with a high dopant concentration, to another wafer, e.g. with a lower dopant concentration like in the standard SOI substrates, occurs within the production line. This leads to unsatisfying dopant profiles in both the p++ type SOI wafers and the standard p- SOI wafers. In addition, during subsequent annealing steps during the Smartcut™ process, a diffusion of dopants out of the highly doped layer occurs which further deteriorates the substrate.

According to an alternative method a standard SOI substrate with a thin p- (or n-) semiconductor layer was used as starting material over which a further semiconductor layer with a p++ dopant concentration was provided. Finally, an additional semiconductor layer with p- concentration was provided to obtain the desired layer structure. With this method it is, however, not possible to reach a sufficient high dopant concentration in the p++ layer and furthermore the dopant concentration is not sufficiently flat, meaning that that the dopant concentration through the layer is not monotonic, but first increasing and then decreasing within the p++ layer.

Starting therefrom, it is the object of the present invention to provide a semiconductor substrate manufacturing process with which improved semiconductor substrates of the above described type can be achieved, thus which represent an improved dopant profile, in particular, in the highly doped p++ layer.

This object is achieved with the method according to claim 1. This method comprises the steps of: a) providing a silicon on insulator (SOI) type substrate comprising a base, an insulating layer and a first semiconductor layer, b) doping the first semiconductor layer to thereby obtain a modified first semiconductor layer, and c) providing a second semiconductor layer with a different dopant concentration than the modified first semiconductor layer over, in particular on, the modified first semiconductor layer, steps b) and c) are carried out in the same fabrication device. In particular an epi-reactor.

With this method an improved semiconductor substrate can be achieved as, the dopant concentration of the modified first semiconductor layer is established only once the SOI type substrate itself has been prepared. Thus, during the fabrication process of the SOI substrate itself, the same kind of donor substrates like in the standard procedure can be provided. Therefore, no cross-contamination from donor wafers with different dopant concentrations is observed and the dopant profile can not be deteriorated by annealing steps in the SOI fabrication procedure.

Preferably, the dopant concentration in the modified first semiconductor layer is higher than in the second semiconductor layer. Like already mentioned this kind of substrate plays an important role, in particular, in optoelectronic applications and with the improved dopant concentration profile which can be achieved with the inventive method, improved final products are obtained.

Advantageously, the second semiconductor layer can be epitaxially grown over, in particular on, the modified first semiconductor layer. By doing so, the quality of the substrate can be further improved.

Preferably, the modified first semiconductor layer can be a highly doped n++ or p++ semiconductor layer, thus with a dopant concentration in the range of 10¹⁷atoms/cm³ up to 10²⁰atoms/cm³. Thus, with this method, the high dopant concentrations necessary for high quality image sensors can be achieved with an improved dopant concentration profile through the different layers.

Preferably, in step c), the second semiconductor layer is provided as an n- or p-semiconductor layer. Dopant concentrations in the range of 1 x 10¹⁴ to 1 x 10¹⁶ atoms/cm³ can be achieved with a clear interface between the highly doped first semiconductor layer and the second semiconductor layer. Thus again, improved substrates can be achieved.

The special provision of a diffusion chamber, which is usually used to dope semiconductor layers, becomes obsolete. Using an epi-reactor for both steps, thus facilitates the production line, due to the fact that one tool, like the diffusion chamber, is no longer part of the production line. In addition, in the epi-reactor the wafers are treated one by one, whereas in the diffusion chambers about 100 wafers are treated at a time.

According to a preferable embodiment, the base can be out of a transparent material. For instance, quartz-type substrates can be employed to provide the transparency of the base substrate with respect to the visible wavelength range, which is necessary for optoelectronic applications.

Advantageously, the (modified) first semiconductor layer can have a thickness in a range of 50 nm to 800 nm, preferably 55 nm to 200 nm and/or the second semiconductor layer can have a thickness in a range of up to 8 µm, and/or the insulating layer can have a thickness of 50 nm to 1500 nm, in particular 100 nm to 400 nm. With the advantageous method, it is possible to provide highly doped and lowly doped semiconductor layers within a wide range of thicknesses. In particular, it is possible to provide a thin highly doped layer in the presence of a thicker lowly doped layer while keeping the desired dopant profile.

Preferably, step a) can comprise the steps of: a1) providing a donor substrate, a2) providing an insulating layer on the donor substrate, a3) creating a predetermined splitting area inside the donor substrate, a4) bonding the donor substrate to the handle substrate, and a5) detaching a remainder of the donor substrate from the bonded donor handle substrate at the predetermined splitting area to thereby form the SOI substrate. With this so called Smartcut™ technology, high quality SOI wafers can be achieved and which can serve in the advantages method, even in cases when only a part of the SOI substrate leaving the production line will be used to create the substrates according to this invention.

As already mentioned above, the inventive methods allows to create a superior substrate which in turn will also improve the qualities of the final product, e.g. the image sensor which uses the substrate.

Advantageous embodiments of the invention will be described in the following in relation to the Figures.
- Figures 1A - 1C: illustrate the steps of one embodiment according to the inventive method for fabricating a semiconductor substrate, and
- Figures 2a - 2b: illustrate a typical dopant concentration profile in a semiconductor substrate fabricated according to the invention in comparison to one fabricated according to the prior art process.

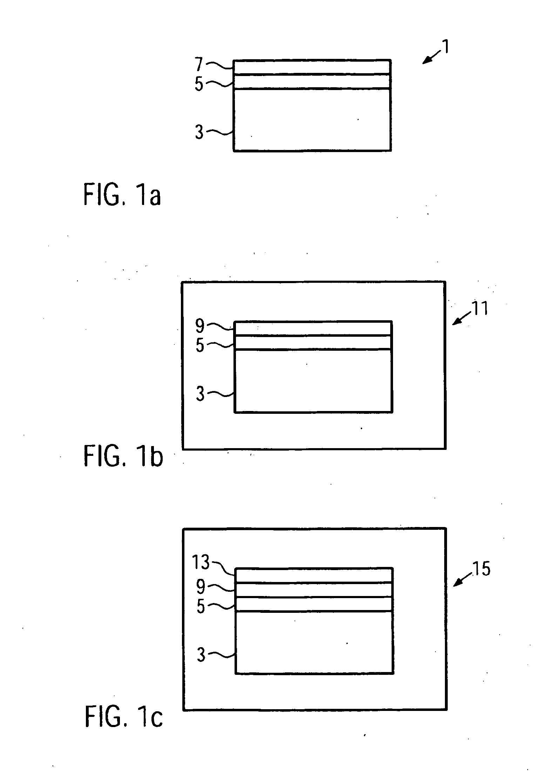

According to step a) of the inventive method, a SOI type substrate 1 is provided as illustrated in figure 1 a. One way to fabricate such a substrate 1 is the so called SmartCut™ technology. This method typically comprises the steps of providing a donor substrate, e.g. a silicon wafer or a transparent substrate like quartz, providing an insulating layer on the donor and/or on the base substrate and creating a predetermined splitting area inside the donor substrate, which is achieved by implanting atomic species or ions, like helium or hydrogen ions, into the donor substrate. In the next step the donor substrate is bonded to a base substrate, e.g. a further silicon wafer, such the insulating layer is sandwiched between handle and donor substrate. Subsequently, the remainder of the donor substrate is detached from the bonded donor-base substrate at the predetermined splitting area following a thermal and/or mechanical treatment upon the predetermined splitting area. As a result a semiconductor on insulator (SOI) substrate is obtained. With this method, the insulating layer finds itself between the semiconductor layer transferred from the donor substrate and the base substrate. This layer then forms the abovementioned buried oxide layer (BOX).

Accordingly the SOI type substrate 1 provided in step a) of the inventive method comprises a base 3, typically silicon. However, depending on the application also other materials are suitable, like for example transparent materials, like quartz, which find their application in optoelectronic applications.

On the base 3, or on the donor, an insulating layer 5 is provided, which is typically a silicon dioxide. However, again other insulating materials like silicon nitride or a stack of layers might also form the insulating layer 5.

Over the insulating layer 5, a first semiconductor layer 7 is provided, which is typically a silicon layer. However, also for this layer, other semiconductor materials like germanium might also be used.

The thickness of the insulating layer is from about 50 nm to 1500 nm, preferably in a range of 100 nm to 400 nm. The semiconductor layer 7 typically has a thickness of 50 nm to 800 nm, preferably 55 nm to 200 nm

According to step b) of claim 1, illustrated in figure 1b, the next step of the inventive method consists in doping the first semiconductor layer 7 to thereby obtain a modified first semiconductor layer 9. Typically, doping is carried out with boron or phosphorous atoms to obtain n-type or p-type kinds of doping in a flow of hydrogen with temperatures of about 900 - 1200°C, preferably 1100 - 1160°C and for a time duration of 30 seconds - 4 minutes. This treatment will turn a p- semiconductor layer into a p++ semiconductor layer with a dopant concentration of 10¹⁷ or more Atoms/cm³ and in case of n- semiconductor layer as first semiconductor layer to an n++ layer with a dopant concentration of 10¹⁷ or more Atoms/cm³.

The next step according to the invention (step c of claim 1) consists in providing a second semiconductor layer 13 with a different dopant concentration than the one of the modified first semiconductor layer 9. This step is typically carried out in a epi-reactor 15 and will result in second semiconductor layer 13 achieved by epitaxial growth on the modified first semiconductor layer 9. For a silicon layer, the used precursor gases can be TCS, DCS, or silane and for doping the layer, again boron or phosphorous n-type or p-type dopants are used. The growth typically takes place at a temperature of 1000 - 1200°C and a layer with a thickness of up to 8 µm can be achieved. The dopant concentration is of the order of 1 x 10¹⁴ to 1 x 10¹⁶ atoms/cm³.

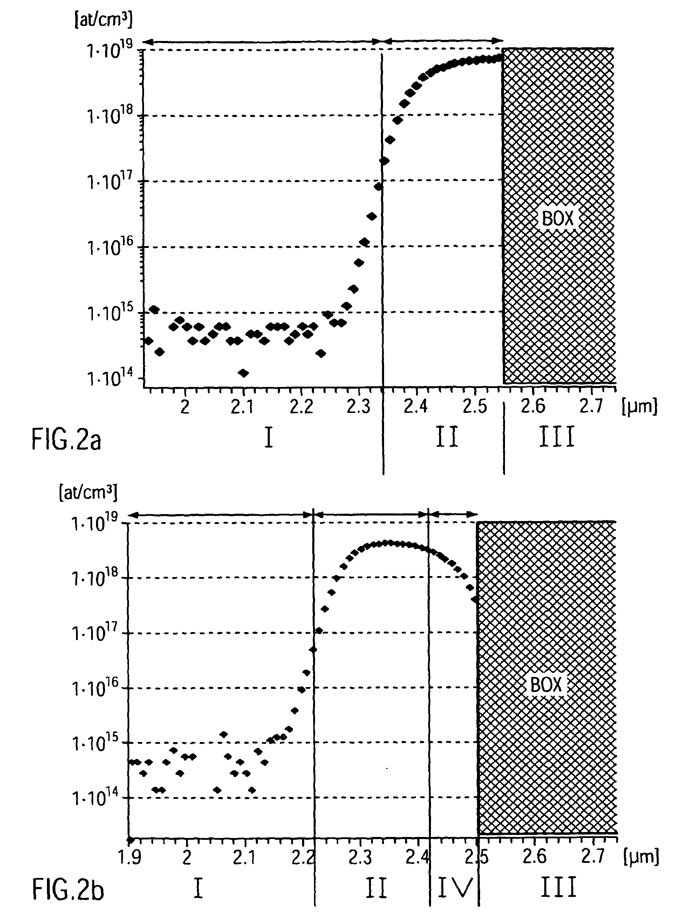

Figures 2a and 2b illustrate dopant concentration profiles of a semiconductor substrate fabricated according to the first embodiment (Figure 2a) and a substrate fabricated according to the prior art method described further above (Figure 2b).

Figure 2a illustrates the dopant concentration on the y axis versus a cross section of the substrate on the x axis. Region I of the dopant concentration corresponds to the second semiconductor layer 13 with a fairly constant dopant concentration of about 4 x 10¹⁴ atoms/cm³. The second Region II corresponds to the modified first semiconductor layer 9 with a dopant concentration going up to 8 x 10¹⁸ atoms/cm³. The highly doped layer 13 has actually a dopant profile which continuously, monotonically, increases and becomes rather flat towards the subsequent buried oxide layer (BOX). This layer has a thickness of 200 nm. Then, the buried oxide insulating layer 5 is represented in Region III. In the shown example, which was fabricated according to the invention, the base substrate 3 was a silicon wafer.

In contrast thereto, Figure 2b illustrates a dopant profile that is achieved with the prior art method in which a standard SOI substrate with a thin p- (or n-) semiconductor layer is used as starting material over which a further semiconductor layer with a p++ (n++) dopant concentration is provided. Like in Figure 1, Region I illustrates the lowly doped semiconductor layer with its dopant concentration of the order of 7 x 10¹⁴ atoms/cm³. Subsequently, in Region II, the highly doped layer has a dopant concentration going up to 7 x 10¹⁸ atoms/cm³. Then follows the thin lowly doped semiconductor layer already present on the starting SOI substrate in Region IV. This layer is thus positioned between the Regions II and the buried oxide layer region III. Due to diffusion, the lowly doped thin semiconductor layer in Region IV has seen its dopant concentration increasing, so that, in the end, the dopant profile of the highly doped layer in Region II first grows (seen from Region I) and then decreases again towards the buried oxide layer. Comparing the two profiles, it appears the for the desired optoelectronic applications, the profile illustrated in Figure 2a is preferable.

According to a second inventive embodiment, the steps illustrated in Figures 1b and 1c are carried out in the same device, namely in the epi-reactor 15, so that, in Figure 1b instead of doping of the first semiconductor layer 7 in an additional diffusion chamber 11, doping is carried out in the epi-reactor 15. This has the advantage that only one tool needs to be provided instead of two. Furthermore, the overall fabrication process is easier to carry out as in the epi-reactor, one wafer after the other is treated, whereas in the diffusion chamber 11. approximately 100 wafers are treated at the same time.

With the described inventive method, the following advantages can be achieved with respect to the known methods in the prior art. With respect to the process for fabricating a semiconductor substrate which starts from a SOI substrate with a p++ or n++ first semiconductor layer, the present invention brings the advantage that dopant cross-contamination risk between lowly doped and highly doped SOI wafers within one manufacturing line can be eliminated and furthermore, due to the doping of the first semiconductor layers 7 in an own doping step, a tailor-made dopant profile can be achieved which is independent of the starting SOI material.

With respect to the method in which the starting material is a standard SOI substrate with a p- semiconductor layer over which a p++/n++ first semiconductor layer is epitaxially grown and over which in turn the p-/n- second layer will be grown is that, with the inventive method, a higher doping concentration can be achieved inside the p++/n++ modified first semiconductor layer 9 and, in addition, the concentration profile in the p++/n++ layer 9 can be kept essentially flat or at least evolves monotonically over its thickness (see figure 2a), whereas it decreases and then increases within the p++/n++ layer with prior art technique (see figure 2b).

Thus, with the inventive method, superior semiconductor substrates can be achieved, which find their application in optoelectronics, in particular in image sensors. With the inventive method it is furthermore possible to have a large process window in terms of doping species, which in addition do not depend on the starting SOI substrate, and to have tailor-made doping levels, which do not depend on the bulk material available.

## Claims

1. Method for fabricating a semiconductor substrate comprising the steps of:
a) providing a silicon on insulator type (SOI) substrate (1) comprising a base (3), an insulating layer (5) and a first semiconductor layer (7),
b) doping the first semiconductor layer (7) to thereby obtain a modified first semiconductor layer (9), and
c) providing a second semiconductor layer (13) with a different dopant concentration than the modified first semiconductor layer (9) over, in particular on, the modified first semiconductor layer (9), and **characterised in that**
step b) and c) are carried out in the same fabrication device (11), in particular an epi-reactor.

2. Method according to claim 1, wherein the dopant concentration in the modified first semiconductor layer (9) is higher than in the second semiconductor layer (13).

3. Method according to claim 1 or 2, wherein the second semiconductor layer (13) is epitaxially grown over, in particular on, the modified first semiconductor layer (9).

4. Method according to one of claims 1 to 3, wherein after doping, the modified first semiconductor layer (9) is a highly doped n++ or p++ semiconductor layer.

5. Method according to one of claims 1 to 4, wherein in step c) the second semiconductor layer (13) is provided as a n- or p- semiconductor layer.

6. Method according to one of claims 1 to 5, wherein the base (3) is out of a transparent material.

7. Method according to one of claims 1 to 6, wherein the modified first semiconductor layer (7, 9) has a thickness in a range of 50nm to 800nm, preferably 55 nm to 200 nm, and/or the second semiconductor layer (13) has a thickness in a range of up to 8µm, and/or the insulating layer (5) has a thickness of 50nm to 1500nm, in particular 100nm to 400nm.

8. Method according to one of claims 1 to 7, wherein step a) comprises:
a1) providing a donor substrate and a base substrate,
a2) providing an insulating layer on the donor substrate or a base substrate,
a3) creating a predetermined splitting area inside the donor substrate,
a4) bonding the donor substrate to the base substrate, and
a5) detaching a remainder of the donor substrate from the bonded donor-base substrate at the predetermined splitting area to thereby transfer a layer of the donor substrate including the insulating layer onto the base substrate to form the SOI substrate.

## Patentansprüche

1. Verfahren zum Herstellen eines Halbleitersubstrats, das die folgenden Schritte umfasst:
a) Bereitstellen eines Substrats (1) vom Typ Silizium auf Isolator (SOI), das einen Träger (3), eine Isolierschicht (5) sowie eine erste Halbleiterschicht (7) umfasst,
b) Dotieren der ersten Halbleiterschicht (7), um so eine modifizierte erste Halbleiterschicht (9) zu gewinnen, und
c) Schaffen einer zweiten Halbleiterschicht (13) mit einer anderen Dotanten-Konzentration als bei der modifizierten ersten Halbleiterschicht (9) über, insbesondere auf der modifizierten ersten Halbleiterschicht (9), **dadurch gekennzeichnet, dass** Schritt b) und c) in der gleichen Herstellungsvorrichtung (11), insbesondere einem Epi-Reaktor, ausgeführt werden.

2. Verfahren nach Anspruch 1, wobei die Dotanten-Konzentration in der modifizierten ersten Halbleiterschicht (9) höher ist als in der zweiten Halbleiterschicht (13).

3. Verfahren nach Anspruch 1 oder 2, wobei die zweite Halbleiterschicht (13) epitaxal über, insbesondere auf der modifizierten ersten Halbleiterschicht (9) gezüchtet wird.

4. Verfahren nach einem der Ansprüche 1 bis 3, wobei nach dem Dotieren die modifizierte erste Halbleiterschicht (9) eine stark dotierte n++- oder p++-Halbleiterschicht ist.

5. Verfahren nach einem der Ansprüche 1 bis 4, wobei in Schritt c) die zweite Halbleiterschicht (13) als eine n- oder p-Halbleiterschicht geschaffen wird.

6. Verfahren nach einem der Ansprüche 1 bis 5, wobei der Träger (3) aus einem transparenten Material besteht.

7. Verfahren nach einem der Ansprüche 1 bis 6, wobei die modifizierte erste Halbleiterschicht (7, 9) eine Dicke im Bereich von 50 nm bis 800 nm, vorzugsweise 55 nm bis 200 nm, hat und/oder die zweite Halbleiterschicht (13) eine Dicke in einem Bereich von bis zu 8 µm hat und/oder die Isolierschicht (5) eine Dicke von 50 nm bis 1500 nm, insbesondere 100 nm bis 400 nm, hat.

8. Verfahren nach einem der Ansprüche 1 bis 7, wobei Schritt a) umfasst:
a1) Bereitstellen eines Donator-Substrats und eines Träger-Substrats,
a2) Schaffen einer Isolierschicht auf dem Donator-Substrat oder einem Träger-Substrat,
a3) Erzeugen eines vorgegebenen Spaltungsbereiches im Inneren des Donator-Substrats,
a4) Bonden des Donator-Substrats an das Träger-Substrat, und
a5) Lösen eines Restes des Donator-Substrats von dem gebondeten Donator-Träger-Substrat an dem vorgegebenen Spaltungsbereich, um so eine Schicht des Donator-Substrats einschließlich der Isolierschicht auf das Träger-Substrat zu überführen und das SOI-Substrat auszubilden.

## Revendications

1. Procédé permettant de fabriquer un substrat semiconducteur comprenant les étapes consistant à :
a) fournir un substrat (1) de type silicium sur isolant (SOI) comprenant une base (3), une couche isolante (5) et une première couche semiconductrice (7),
b) doper la première couche semiconductrice (7) pour obtenir de ce fait une première couche semiconductrice modifiée (9), et
c) fournir une seconde couche semiconductrice (13) présentant une concentration en dopant différente de celle de la première couche semiconductrice modifiée (9) par-dessus, en particulier sur, la première couche semiconductrice modifiée (9), et **caractérisé en ce que**
les étapes b) et c) sont exécutées dans le même composant de fabrication (11), en particulier un épi-réacteur.

2. Procédé selon la revendication 1, dans lequel la concentration en dopant dans la première couche semiconductrice modifiée (9) est supérieure à celle dans la seconde couche semiconductrice (13).

3. Procédé selon la revendication 1 ou 2, dans lequel on fait croître par épitaxie la seconde couche semiconductrice (13) par-dessus, en particulier sur, la première couche semiconductrice modifiée (9).

4. Procédé selon l'une des revendications 1 à 3, dans lequel après le dopage, la première couche semiconductrice modifiée (9) est une couche semiconductrice n++ ou p++ fortement dopée.

5. Procédé selon l'une des revendications 1 à 4, dans lequel, à l'étape c), la seconde couche semiconductrice (13) est fournie comme étant une couche semiconductrice n- ou p-.

6. Procédé selon l'une des revendications 1 à 5, dans lequel la base (3) provient d'un matériau transparent.

7. Procédé selon l'une des revendications 1 à 6, dans lequel la première couche semiconductrice modifiée (7, 9) présente une épaisseur située dans la plage de 50 nm à 800 nm, de préférence de 55 nm à 200 nm, et/ou la seconde couche semiconductrice (13) présente une épaisseur située dans une plage allant jusqu'à 8 µm, et/ou la couche isolante (5) présente une épaisseur de 50 nm à 1500 nm, en particulier de 100 nm à 400 nm.

8. Procédé selon l'une des revendications 1 à 8, dans lequel l'étape a) comprend :
a1) la fourniture d'un substrat donneur et d'un substrat de base,
a2) la fourniture d'une couche isolante sur le substrat donneur ou sur un substrat de base,
a3) la création d'une zone prédéfinie de séparation à l'intérieur du substrat donneur,
a4) la liaison du substrat donneur au substrat de base, et
a5) la séparation du reste du substrat donneur du substrat de base et donneur lié au niveau de la zone prédéfinie de séparation afin de transférer ainsi une couche du substrat donneur incluant la couche isolante sur le substrat de base dans le but de former le substrat SOI.
